# EUROPEAN PATENT APPLICATION

(11) **EP 4 318 856 A1**
(43) Date of publication of application: **07.02.2024**
(21) Application number: 22211677.4
(22) Date of filing: 06.12.2022
(51) Int. Cl.: H02J 7/00, H02J 50/00

(54) **WIRELESS CHARGING ASSEMBLY**

(30) Priority: 01.08.2022 US 202263394010 P
(71) Applicant: Inventec Corporation, Taipei City (TW)
(72) Inventor: HSIAO, Chi-Cheng, Taipei City (TW); PENG, Ying-Chao, Taipei City (TW)
(74) Representative: dompatent von Kreisler Selting Werner - Partnerschaft von Patent- und Rechtsanwälten mbB

(57) **Abstract**

A wireless charging assembly (10) configured to support and charge an electronic device (20). The wireless charging assembly includes a wireless charging host (100) and a fan device (200). The wireless charging host includes a housing (110) and a wireless charging assembly (120). The housing includes a supporting surface (111) and an accommodation space (113). The supporting surface faces away from the accommodation space. The supporting surface is configured to support the electronic device. The wireless charging assembly is disposed in the accommodation space and configured to charge the electronic device. The fan device includes a casing (210) and a fan (240). The fan is disposed in the casing. The casing is disposed on a side of the housing. The fan is configured to blow an airflow to the supporting surface.

## Description

### BACKGROUND OF THE INVENTION

### Technical Field of the Invention

The invention relates to a charging assembly, more particularly to a wireless charging assembly.

### Description of the Related Art

In general, when the wireless charging host charges a smartphone, the electronic components in both of the wireless charging host and the smartphone generate a large amount of heat. Thus, a fan is usually disposed in the wireless charging host to cool the electronic components in the wireless charging host.

However, the fan disposed in the wireless charging host is unable to effectively cool the smartphone placed on an outer surface of the wireless charging host. Accordingly, the heat generated by both of the smartphone and the wireless charging host may accumulate on the smartphone and thus causes the smartphone to break down, especially when the smartphone is executing a complex software.

### SUMMARY OF THE INVENTION

The invention is to provide a wireless charging assembly to effectively cool the electronic devices supported thereon.

One embodiment of this invention provides a wireless charging assembly configured to support and charge an electronic device. The wireless charging assembly includes a wireless charging host and a fan device. The wireless charging host includes a housing and a wireless charging assembly. The housing includes a supporting surface and an accommodation space. The supporting surface faces away from the accommodation space. The supporting surface is configured to support the electronic device. The wireless charging assembly is disposed in the accommodation space and configured to charge the electronic device. The fan device includes a casing and a fan. The fan is disposed in the casing. The casing is disposed on a side of the housing. The fan is configured to blow an airflow to the supporting surface.

According to the wireless charging assembly discussed above, the casing of the fan device is disposed on a side of the housing and the fan is configured to blow an airflow to the supporting surface. Thus, the airflow blown by the fan can effectively cool the electronic devices supported on the wireless charging host. In addition, the fan of the fan device is not disposed in the accommodation space of the wireless charging host, and thus there is no opening or hole on the wireless charging host, thereby preventing foreign materials from entering into the wireless charging host. Further, the airflow that is blown by the fan to the supporting surface not only cools the electronic devices supported on the supporting surface, but also cools the wireless charging host. In this way, the wireless charging host and the electronic devices can be efficiently cooled while allowing the wireless charging host to reach the desired ingress protection rating.

### BRIEF DESCRIPTION OF THE DRAWINGS

The present invention will become more fully understood from the detailed description given hereinbelow and the accompanying drawings which are given by way of illustration only and thus are not limitative of the present invention and wherein:
FIG. 1 is a perspective view of a wireless charging assembly according to an embodiment of the invention and electronic devices;
FIG. 2 is an exploded view of the electronic devices and the wireless charging assembly in FIG. 1;
FIG. 3 is a cross-sectional view of the electronic devices and the wireless charging assembly in FIG. 1; and
FIG. 4 is a partial cross-sectional view of the electronic devices and the wireless charging assembly in FIG. 1.

### DETAILED DESCRIPTION

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

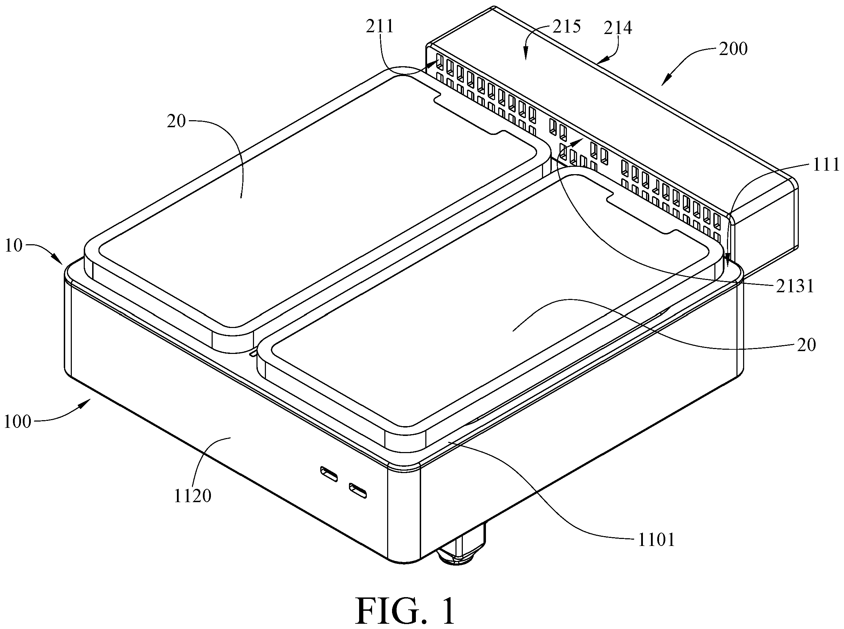

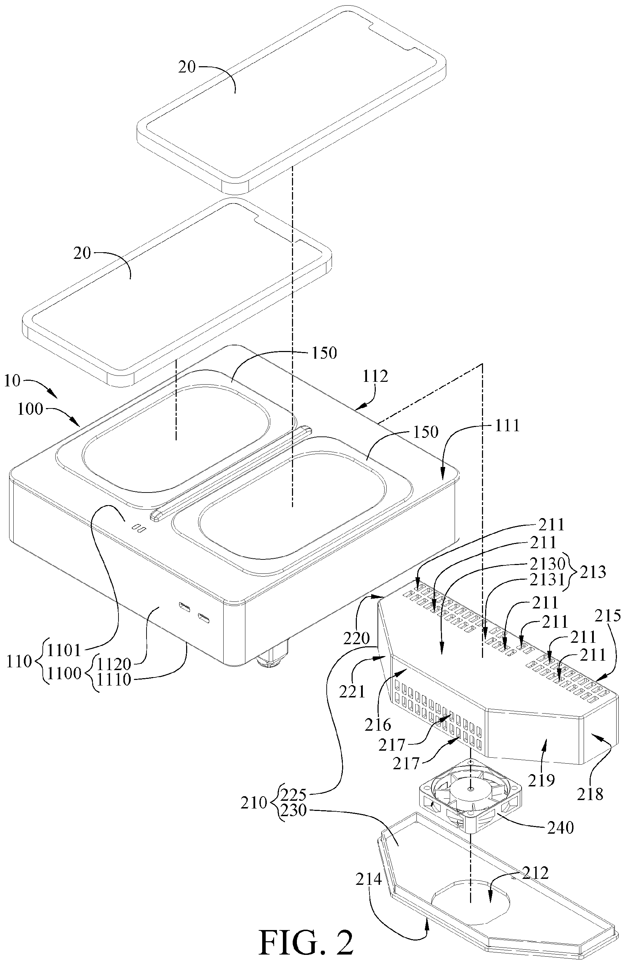

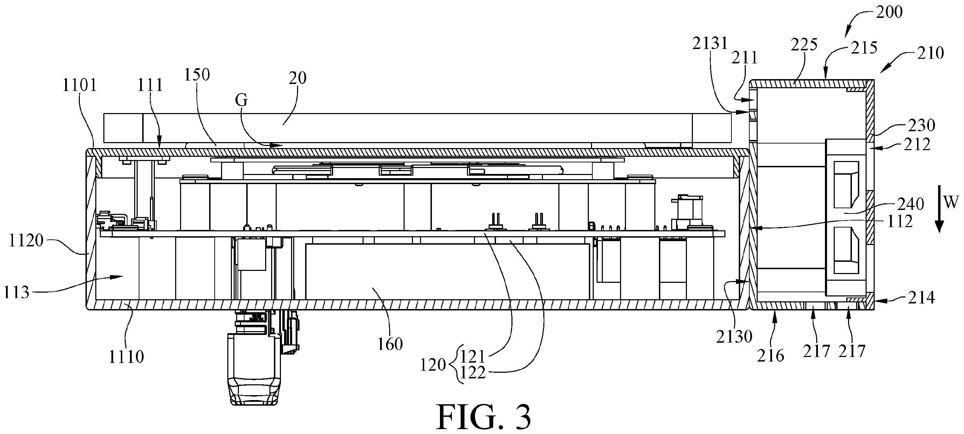

Please refer to FIGS. 1 to 3. FIG. 1 is a perspective view of a wireless charging assembly 10 according to an embodiment of the invention and electronic devices 20. FIG. 2 is an exploded view of the electronic devices 20 and the wireless charging assembly 10 in FIG. 1. FIG. 3 is a cross-sectional view of the electronic devices 20 and the wireless charging assembly 10 in FIG. 1.

In this embodiment, the wireless charging assembly 10 is configured to support and charge two electronic devices 20. The two electronic devices 20 are, for example, smartphones. The wireless charging assembly 10 includes a wireless charging host 100 and a fan device 200.

In this embodiment, the wireless charging host 100 includes a housing 110, a wireless charging assembly 120 and two pads 150. In this embodiment, the housing 110 includes a base 1100, a top plate 1101, a supporting surface 111, a mounting surface 112 and an accommodation space 113. In this embodiment, the base 1100 is made of, for example, metal, such as aluminum alloy. In this embodiment, the base 1100 includes a bottom plate 1110 and a side peripheral plate 1120. The side peripheral plate 1120 stands on the bottom plate 1110. The top plate 1101 is disposed on a side of the side peripheral plate 1120 that is located farthest away from the bottom plate 1110. The bottom plate 1110, the side peripheral plate 1120 and the top plate 1101 together form the accommodation space 113. The supporting surface 111 faces away from the accommodation space 113. In detail, the supporting surface 111 is located on the top plate 1101 and faces away from the base 1100. In addition, the supporting surface 111 is configured to support the two electronic devices 20. The mounting surface 112 faces away from the accommodation space 113 and is located adjacent to the supporting surface 111. Specifically, the mounting surface 112 is located on a side of the side peripheral plate 1120.

In this embodiment, the wireless charging assembly 120 includes a circuit board 121 and a plurality of heat sources 122. The heat sources 122 are disposed on and electrically connected to the circuit board 121. The heat sources 122 are, for example, connectors comporting with Universal Serial Bus Power Delivery (USB PD) standard. The circuit board 121 is disposed in the accommodation space 113. The wireless charging assembly 120 is configured to charge the two electronic devices 20. Note that in other embodiments, the wireless charging assembly may merely include one heat source.

The two pads 150 protrude from the supporting surface 111 of the housing 110. The two pads 150 are configured to support the two electronic devices 20, respectively. Thus, a gap G is formed between the supporting surface 111 and the two electronic devices 20. In other embodiments, the wireless charging assembly may merely support one electronic device, and may merely include one pad.

In this embodiment, the wireless charging host 100 further includes a thermally conductive block 160. The thermally conductive block 160 is located in the accommodation space 113, and is in thermal contact with the heat sources 122 and the base 1100. Specifically, two opposite sides of the thermally conductive block 160 are in thermal contact with the heat sources 122 and the base 1100, respectively. More specifically, two opposite sides of the thermally conductive block 160 are in thermal contact with the heat sources 122 and the bottom plate 1110, respectively. The thermally conductive block 160 is made of a thermally conductive material, such as copper. In this embodiment, the heat sources 122 are, for example, cooled by the thermally conductive block 160 and the base 1100 via passive cooling. In other embodiment, the wireless charging host may not include the thermally conductive block 160, and the heat sources may be cooled via convection.

Please refer to FIGS. 1 to 3, the fan device 200 includes a casing 210 and a fan 240. In this embodiment, the casing 210 includes a main body 225 and a cover body 230. The main body 225 is disposed on the mounting surface 112. The cover body 230 is disposed on a side of the main body 225 that is located farthest away from the mounting surface 112. In this embodiment, the casing 210 includes a first surface 213, a second surface 214, a third surface 215, a fourth surface 216, a first side surface 218, a first inclined surface 219, a second side surface 220, a second inclined surface 221, a plurality of first vents 211, a second vent 212, and a plurality of discharge holes 217 for dissipating one or more foreign materials.

The first surface 213 and the second surface 214 face away from each other. The first surface 213 is located on the main body 225, and the second surface 214 is located on the cover body 230. The first surface 213 is located closer to the housing 110 than the second surface 214, and faces the mounting surface 112. The first surface 213 includes a mounting area 2130 and a vent area 2131 that are connected to each other. The mounting area 2130 is mounted to the mounting surface 112. The first vents 211 are located on the vent area 2131 and exposed to outside at a side of the supporting surface 111. The second vent 212 is located on the second surface 214. The first vents 211 are in fluid communication with the second vent 212.

The third surface 215 and the fourth surface 216 face away from each other, and are located on the main body 225. The third surface 215 and the fourth surface 216 are connected via the first surface 213 and the second surface 214, and are located between the first surface 213 and the second surface 214. The third surface 215 is connected to the vent area 2131 of the first surface 213. The fourth surface 216 is connected to the mounting area 2130 of the first surface 213. Also, in this embodiment, the fourth surface 216 is, for example, located below the third surface 215 along a gravitational direction W. The discharge holes 217 are located on the fourth surface 216. The foreign materials, such as dust or moisture, in the airflow entering into the casing 210 through the first vents 211 or the second vent 212 are allowed to be discharged outside the casing 210 through the discharge holes 217 via gravity.

The first side surface 218 and the second side surface 220 are parallel to each other, and stand on two opposite sides of the third surface 215, respectively. Two opposite sides of the first side surface 218 are connected to the third surface 215 and the first inclined surface 219, respectively. Two opposite sides of the second side surface 220 are connected to the third surface 215 and the second inclined surface 221, respectively. The first inclined surface 219 and the second inclined surface 221 stand on two opposite sides of the fourth surface 216, respectively. Two opposite sides of the first inclined surface 219 are connected to the first side surface 218 and the fourth surface 216, respectively. Two opposite sides of the second inclined surface 221 are connected to the second side surface 220 and the fourth surface 216, respectively. A distance between a side of the first inclined surface 219 connected to the first side surface 218 and a side of the second inclined surface 221 connected to the second side surface 220 is longer than a distance between a side of the first inclined surface 219 connected to the fourth surface 216 and a side of the second side surface 220 connected to the fourth surface 216. With the guide of the first inclined surface 219 and the second inclined surface 221, the foreign materials are facilitated to be dissipated outside the casing 210 through the discharge holes 217. However, in other embodiments, the casing may not include the first inclined surface 219 and the second inclined surface 221, and the first side surface and the second side surface may extend from the third surface to the fourth surface.

The fan 240 is disposed in the casing 210. Specifically, in this embodiment, the fan 240 is fixed to a side of the cover body 230 that is located closest to the main body 225. The fan 240 is, for example, an axial fan.

In this embodiment, as shown in FIG. 2, the discharge holes 217 are evenly located on the fourth surface 216. In other embodiments, the discharge hole may be unevenly located on the fourth surface. Alternatively, in still other embodiments, the casing may merely include one discharge hole. Alternatively, in still other embodiments, the casing may not include the discharge hole 217.

In this embodiment, as shown in FIG. 2, the first vents 211 are unevenly located on the vent area 2131 of the first surface 213, thereby facilitating the main body 225 to be mounted to the mounting surface 112. Specifically, a part of the vent area 2131 without the first vents 211 may allow one or more fasteners (e.g., screws) penetrating through the mounting surface 112 and the main body 225 to be disposed thereon. Note that in other embodiments, the main body may be adhered to the mounting surface and the first vents may be evenly located on the vent area of the first surface. Alternatively, in still other embodiments, the casing may merely include one first vent. Alternatively, in still other embodiments, the casing may be in a plate shape, and the fan may be supported on the casing and exposed to the outside. In such embodiments, the casing is not required to include the first vent 211 and the second vent 212.

In this embodiment, the accommodation space 113 is not in fluid communication with the first vents 211 and the second vent 212. That is, the housing 110 of the wireless charging host 100 does not include or have any opening or hole for a fluid to flow therethrough.

The fan 240 is configured to blow an airflow to the supporting surface 111 through the first vents 211 and the second vent 212. The airflow blown by the fan 240 is configured to cool the base 1100 and the electronic devices 20. In detail, after the heat generated by the heat sources 122 is absorbed by the thermally conductive block 160, the heat is transferred to the base 1100 via the thermally conductive block 160. Then, the airflow blown by the fan 240 cools the base 1100. Note that in this embodiments, no fan is disposed in the accommodation space 113, and the heat sources 122 are cooled by the thermally conductive block 160 and the base 1100 via passive cooling. However, since the fan 240 disposed outside the accommodation space 113 can blow the airflow for cooling the base 1100, the heat transferred from the thermally conductive block 160 to the base 1100 is more effectively dissipated to the outside.

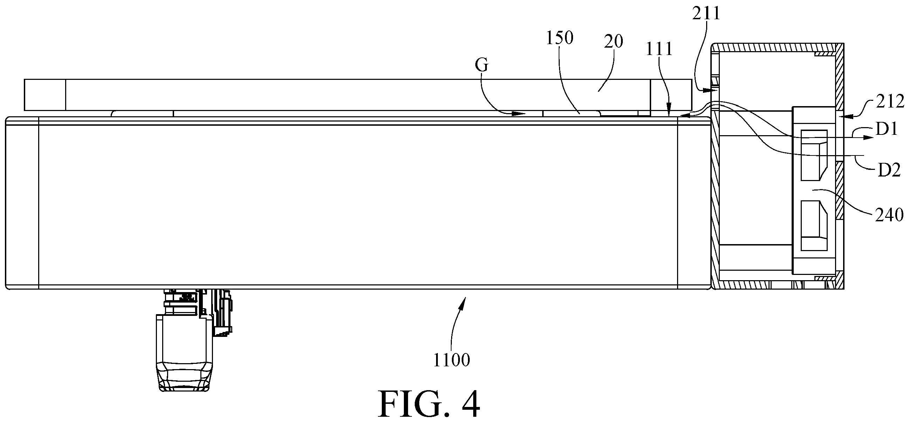

Please refer to FIG. 4. FIG. 4 is a partial cross-sectional view of the electronic devices 20 and the wireless charging assembly 10 in FIG. 1. In this embodiment, the fan 240 has an inhalation mode and an exhaustion mode. When the fan 240 is in the inhalation mode, the fan 240 is configured to blow an airflow from the first vents 211 to the second vent 212 along a first flowing direction D1. For example, when the wireless charging assembly 10 according to the invention is applied to automotive system, one or more passengers are usually located closer to the first vents 211 than the second vent 212. Thus, when the fan 240 is in the inhalation mode, the hot airflow flows from the first vents 211 to the second vent 212 rather than flowing towards the passengers. Therefore, the user experience of the wireless charging assembly 10 for the passengers is enhanced.

When the fan 240 is in an exhaustion mode, the fan 240 blows an airflow from the second vent 212 to the first vents 211 along a second flowing direction D2. When the fan 240 is in the exhaustion mode, the airflow blown by the fan 240 more concentrates on the base 1100 and the electronic devices 20, thereby more efficiently cool the base 1100 and the electronic devices 20.

Note that in this embodiment, as shown in FIG. 3, the first vents 211 are located farther away from the fourth surface 216 than the second vent 212. That is, at least part of the first vents 211 are located above the second vent 212 along the gravitational direction W. Therefore, the foreign materials in the airflow flowing from the first vents 211 to the second vent 212 are facilitated to be dissipated outside the casing 210 through the discharge holes 217. However, in other embodiments, the first vents may be located closer to the fourth surface than the second vent, and the foreign materials in the airflow flowing from the second vent to the first vents are facilitated to be dissipated outside the casing through the discharge holes.

According to the wireless charging assembly discussed above, the casing of the fan device is disposed on a side of the housing and the fan is configured to blow an airflow to the supporting surface. Thus, the airflow blown by the fan can effectively cool the electronic devices supported on the wireless charging host. In addition, the fan of the fan device is not disposed in the accommodation space of the wireless charging host, and thus there is no opening or hole on the wireless charging host, thereby preventing foreign materials from entering into the wireless charging host. Further, the airflow that is blown by the fan to the supporting surface not only cools the electronic devices supported on the supporting surface, but also cools the wireless charging host. In this way, the wireless charging host and the electronic devices can be efficiently cooled while allowing the wireless charging host to reach the desired ingress protection rating.

For example, the wireless charging assembly according to this invention comports with IP54 rating.

In one embodiment of the invention, the wireless charging assembly according to the invention may be applied to self-driving vehicle, electric vehicle, or semi-self-driving vehicle.

It will be apparent to those skilled in the art that various modifications and variations can be made to the present invention. It is intended that the specification and examples be considered as exemplary embodiments only, with a scope of the invention being indicated by the following claims and their equivalents.

## Claims

1. A wireless charging assembly (10), configured to support and charge an electronic device (20), the wireless charging assembly comprising:
a wireless charging host (100), comprising a housing (110) and a wireless charging assembly (120), wherein the housing comprises a supporting surface (111) and an accommodation space (113), the supporting surface faces away from the accommodation space, the supporting surface is configured to support the electronic device, and the wireless charging assembly is disposed in the accommodation space and configured to charge the electronic device; and
a fan device (200), comprising a casing (210) and a fan (240), wherein the fan is disposed in the casing, the casing is disposed on a side of the housing, and the fan is configured to blow an airflow to the supporting surface.

2. The wireless charging assembly according to claim 1, wherein the casing comprises at least one first vent (211) and a second vent (212) that are in fluid communication with each other, the at least one first vent is located on a side of the casing that is located closest to the housing, and the fan is configured to blow the airflow to the supporting surface through the at least one first vent and the second vent.

3. The wireless charging assembly according to claim 2, wherein the housing further comprises a mounting surface (112), the mounting surface faces away from the accommodation space and is located adjacent to the supporting surface, the casing of the fan device further comprises a first surface (213) and a second surface (214) facing away from each other, the first surface is located closer to the housing than the second surface and faces the mounting surface, the first surface comprises a mounting area (2130) and a vent area (2131) that are connected to each other, the mounting area is mounted to the mounting surface, the at least one first vent is located on the vent area and exposed to outside at a side of the supporting surface, and the second vent is located on the second surface.

4. The wireless charging assembly according to claim 3, wherein the casing of the fan device further comprises a third surface (215), a fourth surface (216) and at least one discharge hole (217), the third surface and the fourth surface face away from each other, the third surface and the fourth surface are connected by the first surface and the second surface and are located between the first surface and the second surface, the third surface is connected to the vent area of the first surface, the fourth surface is connected to the mounting area of the first surface, and the at least one discharge hole is located on the fourth surface.

5. The wireless charging assembly according to claim 4, wherein the casing of the fan device further comprises a first side surface (218), a first inclined surface (219), a second side surface (220) and a second inclined surface (221), the first side surface and the second side surface are parallel to each other and stand on two opposite sides of the third surface, respectively, two opposite sides of the first side surface are connected to the third surface and the first inclined surface, respectively, two opposite sides of the second side surface are connected to the third surface and the second inclined surface, respectively, the first inclined surface and the second inclined surface stand on two opposite sides of the fourth surface, respectively, two opposite sides of the first inclined surface are connected to the first side surface and the fourth surface, respectively, two opposite sides of the second inclined surface are connected to the second side surface and the fourth surface, respectively, a distance between a side of the first inclined surface connected to the first side surface and a side of the second inclined surface connected to the second side surface is longer than a distance between a side of the first inclined surface connected to the fourth surface and a side of the second inclined surface connected to the fourth surface.

6. The wireless charging assembly according to claim 4, wherein the at least one first vent is located farther away from the fourth surface than the second vent.

7. The wireless charging assembly according to claim 2, wherein the at least one first vent comprises a plurality of first vents, and the plurality of first vents are unevenly located on the side of the casing that is located closest to the housing.

8. The wireless charging assembly according to claim 2, wherein the housing of the wireless charging host further comprises a base (1100) and a top plate (1101), the top plate is disposed on a side of the base, the supporting surface is located on the top plate and faces away from the base, the base and the top plate together form the accommodation space, the casing of the fan device is disposed on a side of the base, and the base is made of metal.

9. The wireless charging assembly according to claim 8, wherein the wireless charging host further comprises a thermally conductive block (160), the wireless charging assembly comprises a circuit board (121) and at least one heat source (122), the at least one heat source is disposed on and electrically connected to the circuit board, the circuit board is disposed in the accommodation space, and the thermally conductive block is located in the accommodation space and in thermal contact with the at least one heat source and the base.

10. The wireless charging assembly according to claim 9, wherein the accommodation space is not in fluid communication with the at least one first vent and the second vent.

11. The wireless charging assembly according to claim 9, wherein two opposite sides of the thermally conductive block are in thermal contact with the at least one heat source and the base, respectively.

12. The wireless charging assembly according to claim 11, wherein the base comprises a bottom plate (1110) and a side peripheral plate (1120), the side peripheral plate stands on the bottom plate, the top plate is disposed on a side of the side peripheral plate that is located farthest away from the bottom plate, the bottom plate, the side peripheral plate and the top plate together form the accommodation space, and two opposite sides of the thermally conductive block are in thermal contact with the at least one heat source and the bottom plate, respectively.

13. The wireless charging assembly according to claim 3, wherein the casing of the fan device comprises a main body (225) and a cover body (230), the main body is disposed on the mounting surface, the cover body is disposed on a side of the main body that is located farthest away from the mounting surface, the first surface and the at least one first vent are located on the main body, and the second surface and the second vent are located on the cover body.

14. The wireless charging assembly according to claim 13, wherein the fan is fixed to a side of the cover body that is located closest to the main body.

15. The wireless charging assembly according to claim 3, wherein the fan has an inhalation mode and an exhaustion mode, when the fan is in the inhalation mode, the fan is configured to blow the airflow from the at least one first vent to the second vent; when the fan is in the exhaustion mode, the fan is configured to blow the airflow from the second vent to the at least one first vent.
